# EUROPÄISCHE PATENTSCHRIFT

(11) **EP 2 848 949 B1**
(45) Veröffentlichungstag und Bekanntmachung des Hinweises auf die Patenterteilung: **05.12.2018**
(21) Anmeldenummer: 14177442.2
(22) Anmeldetag: 17.07.2014
(51) Int. Cl.: G01R 27/18, H02H 3/17

(54) **Verfahren und Vorrichtung zur Überwachung eines Isolationswiderstandes in einem ungeerdeten Stromversorgungssystem**
Method and device for monitoring an insulation resistance in a non-earthed power supply system
Procédé et dispositif de surveillance d'une résistance d'isolement dans un système d'alimentation en courant non mis à la terre

(30) Priorität: 16.09.2013 DE 102013218525
(43) Veröffentlichungstag der Anmeldung: 18.03.2015
(73) Patentinhaber: Bender GmbH & Co. KG, 35305 Grünberg (DE)
(72) Erfinder: Geiß, Manfred, 35327 Ulrichstein (DE); Haub, Dennis, 35428 Langgöns (DE)
(74) Vertreter: advotec.

(56) Entgegenhaltungen:
- EP-A1- 2 530 801
- WO-A1-2013/081310
- US-A- 3 737 765
- US-A- 4 472 676
- ZENG XIANGJUN ET AL: "Improvement of subharmonic injection schemes for huge hydro-generator stator ground fault protection", POWER SYSTEM TECHNOLOGY, 2002. PROCEEDINGS. POWERCON 2002. INTERNATION AL CONFERENCE ON, PISCATAWAY, NJ, USA,IEEE, Bd. 2, 13. Oktober 2002 (2002-10-13), Seiten 707-710, XP010614845, ISBN: 978-0-7803-7459-1
- HARRIS F J: "ON THE USE OF WINDOWS FOR HARMONIC ANALYSIS WITH THE DISCRETE FOURIER TRANSFORM", PROCEEDINGS OF THE IEEE, IEEE. NEW YORK, US, vol. 66, no. 1, 1 January 1978 (1978-01-01), pages 51-84, XP000568030, ISSN: 0018-9219

## Beschreibung

Die Erfindung betrifft ein Verfahren zur Überwachung eines Isolationswiderstandes in einem ungeerdeten Stromversorgungssystem mit einer Netzfrequenz, umfassend die Verfahrensschritte: Erzeugen einer harmonischen Wechselspannung als Messspannung mit einer einstellbaren Messfrequenz, Einkoppeln der Messspannung zwischen mindestens einem Leiter des Stromversorgungssystems und Erdpotential, Erfassen eines einem komplexwertigen Isolationswiderstand proportionalen Messstroms zwischen dem Leiter des Stromversorgungssystems und Erdpotential durch Abtastung der an einem reellen Messwiderstand abfallenden Spannung, wobei die Abtastwerte eine Folge von Spannungs-Messwerten mit einer Abtastperiode bilden, Verwenden der Spannungs-Messwerte zur Bestimmung des komplexwertigen Isolationswiderstands.

Des Weiteren betrifft die Erfindung eine Vorrichtung zur Durchführung des beanspruchten Verfahrens.

Um eine hohe Verfügbarkeit und Betriebssicherheit der elektrischen Stromversorgung sicherzustellen sowie die Personensicherheit im Aufenthaltsbereich elektrischer Anlagen zu gewährleisten, sind Stromversorgungssysteme im Einsatz, deren aktive Teile von dem Erdpotential getrennt sind. Bei dieser ungeerdeten, auch als IT-System bezeichneten Art des Stromversorgungsnetzes kann ein Leiter einen Isolationsfehler aufweisen, ohne dass der laufende Betrieb der Anlage unterbrochen werden muss, weil sich wegen des im Idealfall unendlich großen Widerstandswertes zwischen Leiter und Erde in diesem ersten Fehlerfall kein geschlossener Stromkreis ausbilden kann.

Der elektrische Widerstand zwischen Leiter und Erde stellt sich als komplexwertige Größe dar, deren Realteil durch den ohmschen (Isolations-)Widerstand bestimmt wird und deren imaginäre Komponente durch die Netzableitkapazität gebildet wird. Wenn im Folgenden der Begriff Isolationswiderstand ohne nähere Bestimmung verwendet wird, so soll darunter der ohmsche Anteil verstanden werden. Betrifft der Sachverhalt sowohl die ohmsche als auch die kapazitive Komponente, so wird von dem komplexwertigen oder komplexen Isolationswiderstand gesprochen.

Als Isolationsfehler wird ein fehlerhafter Zustand des IT-Systems bezeichnet, der zum Absinken des Isolationswiderstands unter das zulässige Isolationsniveau führt. Aus dieser Betrachtung geht hervor, dass der Widerstand in dem zu überwachenden Netz gegen Erde ständig überwacht werden muss, da durch einen möglichen weiteren Fehler an einem anderen Leiter (zweiter Fehler) eine Fehlerschleife entstünde und der dabei fließende Fehlerstrom in Verbindung mit einer Überstrom-Schutzeinrichtung eine Abschaltung der Anlage mit Betriebsstillstand zur Folge hätte.

Aus dem Stand der Technik sind aktiv messende Verfahren zur Isolationsüberwachung bekannt, zu deren Umsetzung ein Isolationsüberwachungsgerät in den Hauptzweig des IT-Systems zwischen den Netzleitern und Erde angeschlossen wird und dem Netz eine Messspannung überlagert, die zu einem dem komplexen Isolationswiderstand proportionalen Stromfluss führt. Dieser Messstrom verursacht an einem Messwiderstand des Isolationsüberwachungsgerätes einen Spannungsabfall, der ausgewertet wird und bei Überschreiten eines voreinstellbaren Grenzwertes eine Warnmeldung zur Folge hat.

An dem Messwiderstand fällt stets die aus Netzspannung und Messspannung überlagerte (Gesamt-)Spannung ab. Insbesondere in Stromversorgungssystemen, die mit einer Wechselspannung bestimmter Netzfrequenz betrieben werden und in denen wegen der Unempfindlichkeit gegenüber störenden Gleichspannungsanteilen sowie zur Bestimmung des komplexwertigen Isolationswiderstands eine erforderliche Wechselspannung bestimmter Messfrequenz als Messspannung eingekoppelt wird, stellt die Netzspannung ein Störsignal bei der Auswertung der Spannungs-Messwerte im Hinblick auf die Bestimmung des komplexen Isolationswiderstands dar. Man ist daher bestrebt, die Messfrequenz so zu wählen, dass sich durch geeignete Filterschaltungen mit vertretbarem Aufwand eine spektrale Trennung zwischen Messspannung (Nutzsignal) und Netzspannung (Störsignal) erreichen lässt.

Da der kapazitive Leitwert, also die Netzableitkapazität, mit steigender Frequenz zunimmt und die Bestimmung des ohmschen Anteils des komplexen Isolationswiderstands durch zu hohe kapazitive Ableitströme verfälschen würde, wird man die Messfrequenz möglichst niedrig wählen. Allerdings sind der gewünschten Ausweitung des Messfrequenzbereichs nach tiefen Frequenzen hin durch die langsam verlaufenden Einschwingvorgänge auf der Leitung, und bei transformatorischer Einkopplung auch durch die erforderliche Transformatorgröße zur Erzielung einer induzierten (Mindest-)Spannung, Grenzen gesetzt.

Aus der EP 2 530 801 A1 ist ein Fehlerstrom-Schutzsystem bekannt, welches vornehmlich bei dreiphasigen elektrischen Maschinen in störungsbehafteter Umgebung eingesetzt wird. Das Messverfahren zur Bestimmung eines Fehlerwiderstands beruht auf der Einspeisung einer Messsignalspannung, deren Frequenz adaptiv in Abhängigkeit eines gemessenen Rauschspektrums eingestellt wird.

Die US-Patentschrift US 4,472,676 A zeigt ein System zur Messung der Ableitimpedanz, bei dem das in das Leiternetz eingespeiste Testsignal nur eine geringe Frequenzabweichung von der Netzfrequenz aufweist. Durch Auswertung des durch Überlagerung von Testspannung und Netzspannung entstehenden Interferenzmusters der Gesamtspannung kann bei bekanntem eingeprägten Messstrom ein der Ableitimpedanz proportionaler Spannungsabfall gemessen werden. WO2013/081310 offenbart ein System zur Messung der Isolationsimpedanz unter Verwendung der diskreten Fouriertransformation (DFT)
Der vorliegenden Erfindung liegt somit die Aufgabe zu Grunde, ein Verfahren und eine Vorrichtung zur Überwachung des Isolationswiderstandes in einem ungeerdeten Wechselstromversorgungssystem zu entwickeln, die eine sichere Überwachung des ohmschen Anteils des Isolationswiderstands sowie eine zuverlässige und schnelle Bestimmung des komplexen Isolationswiderstands erlauben.

Diese Aufgabe wird in Verbindung mit dem Oberbegriff des Anspruchs 1 sowie des Anspruches 9, dadurch gelöst, dass eine Synchronisation der Messfrequenz auf die Netzfrequenz durchgeführt wird und eine Signalperiode der Spannungs-Messwerte gespeichert und einer diskreten Fourier-Transformation unterworfen wird, wobei die spektralen Komponenten der Netzspannung bei einer Rechteck-Fensterung im Zeitbereich in den Nullstellen einer si-Funktion im Spektralbereich zu liegen kommen. Die an dem Messwiderstand abfallende Spannung stellt eine reelle Zeitfunktion dar, die durch Abtastung in eine zeitdiskrete Signalfolge überführt wird, deren Zahlenwerte die Spannungs-Messwerte repräsentieren. Der Grundgedanke der vorliegenden Erfindung beruht nun darauf, eine Synchronisation in Form einer festen Frequenz- und Phasenbeziehung zwischen der Netzspannung und der Messspannung herzustellen und eine netzsynchrone Signalperiode der Spannungs-Messwerte einer diskreten Fourier-Transformation (DFT) zu unterwerfen, mit dem Ziel, die Netzspannung als Störquelle weitgehend eliminieren zu können und dadurch eine schnelle und zuverlässige Bestimmung des komplexen Isolationswiderstands zu erreichen.
Die Spannungs-Messwerte werden somit nicht unmittelbar im Zeitbereich zur Bestimmung des komplexen Isolationswiderstandes herangezogen, sondern zunächst wird die Frequenz der Messspannung (Messfrequenz) auf die Netzfrequenz synchronisiert und anschließend die Information, die in den synchronisierten Spannungs-Messwerten enthalten ist, nach Transformation in den Spektralbereich zur Bestimmung des komplexen Isolationswiderstands weiterverarbeitet.
Durch die erfindungsgemäße Synchronisation mit nachfolgender DFT ist es möglich, insbesondere die durch die Netzfrequenz hervorgerufenen Störanteile in der an dem Messwiderstand gemessenen Gesamtspannung weitgehend zu eliminieren, so dass im Spektralbereich an der erwarteten Frequenzstelle der Messspannung die Messsignalkomponente unverfälscht zur Verfügung steht.

Dadurch kann die Überwachung des (komplexen) Isolationswiderstands einschließlich der Bestimmung seines ohmschen und kapazitiven Anteils zuverlässig durchgeführt werden.

Da weiterhin die Bestimmung des komplexwertigen Isolationswiderstands auf der Verwendung nur einer Signalperiode der Spannungsmesswerte beruht, ist zudem eine schnelle Bereitstellung aktueller komplexer Isolationswiderstandswerte gewährleistet.

In weiterer vorteilhafter Ausgestaltung umfasst die Synchronisation der Messfrequenz auf die Netzfrequenz die Schritte: Messung der Netzfrequenz und Nachsteuern der Messfrequenz bei einer Änderung der Netzfrequenz, so dass die Messfrequenz und die Netzfrequenz in einem geradezahligen Teilerverhältnis zueinander stehen.

Bevorzugt beträgt das geradezahlige Teilerverhältnis 2^{m} = f_{Netz}/fₘₑₛₛ.

Zunächst wird in festgelegten Zeitabständen wiederkehrend eine Messung der Netzfrequenz ausgeführt. Dies kann beispielsweise dadurch geschehen, dass jeder positive Netzspannungsdurchgang einen absoluten Zeitstempel erhält, wodurch sich aus zwei unmittelbar aufeinanderfolgend detektierten Nulldurchgängen die Netzfrequenz bestimmen lässt. Wird eine Änderung der Netzfrequenz festgestellt, so wird in einem nächsten Schritt der einspeisende Messsignalgenerator veranlasst, die Messfrequenz so nachzusteuern, dass diese mit der Netzfrequenz in einem geradezahligen Teilerverhältnis steht. Dies hat zur Folge, dass, wie nachstehend erläutert, der störende Einfluss der Netzspannung auf die Messspannung reduziert wird.

Bei der zu transformierenden Signalperiode handelt es sich um ein zeitbegrenztes Signal, welches im Zeitbereich durch eine Rechteck-Fensterung erzeugt wird. Dem entspricht im Frequenzbereich eine Bewertung der transformierten Spannungs-Messwerte mit einer si-Funktion (sin x/x - Funktion), die als Selektivität der DFT interpretiert werden kann.

Auf Grund der Synchronisationsmechanismen wird in erfindungsgemäßer Weise die Wirkung erzielt, dass die spektralen Komponenten der Netzspannung in ihrer unerwünschten Funktion als Störer idealerweise in den Nullstellen der si-Funktion, also außerhalb der Haupt- und Nebenkeulen, zu liegen kommen. Durch diese Ausblendung der Netzspannung als Störkomponente im Frequenzspektrum ist eine zuverlässige Bestimmung des komplexen Isolationswiderstands möglich.
Vorzugsweise erfolgt die Messung der Netzfrequenz periodisch nach einer einstellbaren Anzahl von n Abtastperioden.
In welchen Zeitabständen die Messung der Netzfrequenz durchgeführt wird, kann durch die Anzahl n der Abtastperioden festgelegt werden.
Eine erneute Messung beispielsweise nach jeder Abtastung (n=l) bewirkt eine schnelle Aktualisierung des zu bestimmenden komplexen Isolationswiderstands, verlangt aber entsprechende Rechenleistung.
Bevorzugt werden bei einer Änderung der Netzfrequenz die zeitältesten n Spannungs-Messwerte der gespeicherten Signalperiode durch die aktuellen n Abtastwerte ersetzt.
Wird nach Messung der Netzfrequenz eine Änderung der Netzfrequenz festgestellt, so findet eine Aktualisierung der Abtastung der zu transformierenden Spannungs-Messwerte statt. Dabei werden die n zeitältesten Abtastwerte der zu transformierenden Signalperiode durch die aktuellen n Abtastwerte ersetzt und die so aktualisierte Signalperiode der DFT unterzogen. Durch die mit jeder festgestellten Änderung der Netzfrequenz einhergehende fortlaufende Aktualisierung stehen jeweils Spannungs-Messwerte zur Verfügung, deren Fourier-Transformierte einen weitgehend ausgeblendeten netzfrequenten Störanteil aufweist.

Die einstellbare Anzahl n der zu aktualisierenden Spannungs-Messwerte kann einen Spannungs-Messwert bis alle eine gesamte Signalperiode repräsentierenden Spannungs-Messwerte umfassen.

Wie zuvor angemerkt, erfolgt eine erneute Messung der Netzfrequenz und damit eine Aktualisierung der Abtastung der zu transformierenden Spannungs-Messwerte nach n Abtastperioden. Das durch die Anzahl n der Abtastperioden bestimmte Aktualisierungsintervall ist dabei zwischen n=l (für jeden neuen Abtastwert findet eine Aktualisierung statt) und n gleich der Anzahl aller Abtastwerte einer Signalperiode (alle Abtastwerte einer Signalperiode werden blockweise ersetzt) einstellbar. Beispielsweise ist als Kompromiss zwischen schneller Aktualisierung und erforderlicher Rechenleistung die Aktualisierung der Abtastwerte einer Halb- oder einer Viertelperiode möglich.

In weiterer vorteilhafter Ausgestaltung wird die komplexwertige diskrete Fourier-Transformierte der Spannungs-Messwerte als Grundlage zur Bestimmung eines ohmschen und eines kapazitiven Anteils des Isolationswiderstands verwendet.

In Abhängigkeit der Symmetrieeigenschaften der aus den Spannungs-Messwerten gebildeten reellen Abtastwertfolge besitzt deren diskrete Fourier-Transformierte einen Real- und Imaginärteil, die zur Bestimmung des ohmschen und des kapazitiven Anteils des komplexen Isolationswiderstands herangezogen werden. Dabei verlaufen die digitale Erzeugung der harmonischen Messspannung mit der einstellbaren Messfrequenz und die zeitdiskrete Auswertung mittels der DFT streng synchron zueinander, wobei zu jedem Abtastzeitpunkt die Werte der Kosinus- und Sinus-Basisfunktion der DFT-Operationen phasenrichtig vorliegen müssen.

Mit Vorteil wird eine Störsignalerkennung mit nachfolgender Unterdrückung des ermittelten Isolationswiderstands durchgeführt.

Die Bestimmung des Isolationsniveaus soll neben der geforderten Schnelligkeit außerdem zuverlässig erfolgen. Diese Anforderung beinhaltet unter anderem, dass kurzzeitige Störungen nicht zu Fehlauslösungen führen dürfen. Um dies zu gewährleisten, umfasst das Verfahren zur Ermittlung des Isolationsniveaus weiterhin eine schnelle Störsignalerkennung, die zu einer Messwertunterdrückung, d.h. zur Unterdrückung des bestimmten Isolationswiderstandswertes führt. Die Störsignalerkennung und Messsignalunterdrückung bestehen aus einer Kombination von Prüfungen und beruhen wie die Bestimmung des komplexen Isolationswiderstandswertes selbst auf der Betrachtung des Amplitudenverlaufs der Netzspannung. Nach der Erkennung der Störung werden für die Dauer der erkannten Störung die Messergebnisse für den Isolationswiderstand unterdrückt. Diese Prüfungen zur Erkennung weiterer Störer umfassen beispielsweise eine Prüfung auf Über- und Unterschreiten der Grenzwerte der AD-Umsetzer, die Prüfung, ob eine kurzzeitige Nicht-Detektierbarkeit der Netzfrequenz vorliegt oder eine Analyse und Plausibilisierung des Amplitudenverlaufes der Netzspannung.

Bezogen auf eine Vorrichtung zur Durchführung des beanspruchten Verfahrens wird die Aufgabe in Verbindung mit dem Oberbegriff des Anspruchs 9 gelöst durch eine Recheneinheit zur Ausführung einer Synchronisation der Messfrequenz auf die Netzfrequenz, zur Ausführung einer diskreten Fourier-Transformation und zur Ausführung von Berechnungen zur Bestimmung des komplexwertigen Isolationswiderstands auf der Grundlage der diskreten Fourier-Transformierten sowie eine Speichereinheit zur Speicherung einer Signalperiode der Spannungs-Messwerte.

Die Vorrichtung zur Überwachung eines Isolationswiderstandes in einem ungeerdeten Stromversorgungssystem weist somit erfindungsgemäß eine Recheneinheit auf, die den Synchronisationsablauf steuert sowie die Berechnungen für die diskrete Fourier-Transformation und einen anschließenden Algorithmus zur Überführung der spektralen Information in den komplexwertigen Isolationswiderstand ausführt. Weiterhin umfasst die Vorrichtung eine Speichereinheit in Funktion eines Pufferspeichers zur Zwischenspeicherung einer Signalperiode der Spannungs-Messwerte.

Weitere vorteilhafte Ausgestaltungsmerkmale ergeben sich aus der nachfolgenden Beschreibung und den Zeichnungen, die bevorzugte Ausführungsformen der Erfindung an Hand von Beispielen erläutern. Es zeigen:
- **Fig. 1:**: eine schematische Darstellung eines Messspannungskreises mit einer erfindungsgemäßen Vorrichtung zur Überwachung eines Isolationswiderstands in einem ungeerdeten Stromversorgungssystem,
- **Fig. 2:**: ein funktionales Blockdiagramm der erfindungsgemäßen Vorrichtung.

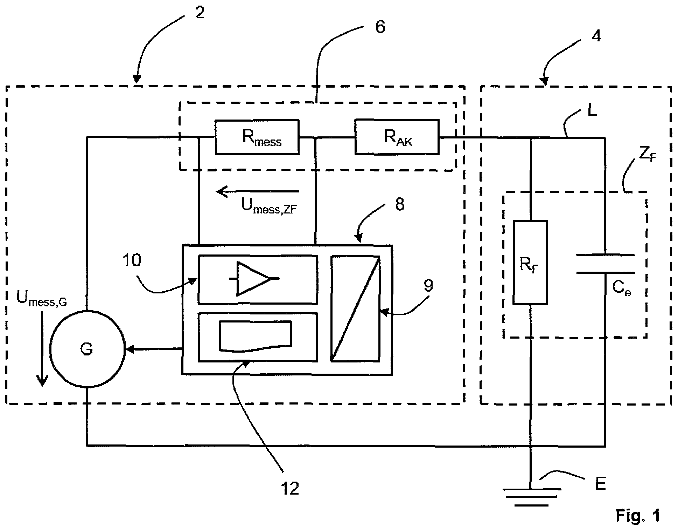

Die **Fig. 1** zeigt eine schematische Darstellung eines Messspannungskreises mit einer erfindungsgemäßen Vorrichtung 2 zur Überwachung eines (ohmschen) Isolationswiderstandes R_{F} und zur Bestimmung eines komplexen Isolationswiderstands Z_{F} mit dem ohmschen Anteil R_{F} und einer Netzableitkapazität Cₑ in einem ungeerdeten Stromversorgungssystem 4.

Die Überwachungsvorrichtung 2 umfasst eine Signalgeneratorschaltung G, eine Ankoppelschaltung 6 und eine Auswerteschaltung 8.

Die Signalgeneratorschaltung G erzeugt eine netzsynchrone Messspannung U_{mess,G}, die über die Ankopplungsschaltung 6, bestehend aus einem Ankoppelwiderstand R_{AK} und einem Messwiderstand Rₘₑₛₛ, in das Stromversorgungssystem 4 zwischen einem Leiter L des Stromversorgungssystems 4 und Erdpotential E eingekoppelt wird. Zur Auswertung und Verarbeitung der an dem Messwiderstand Rₘₑₛₛ abgenommenen Spannung U_{mess,ZF} weist die Überwachungsvorrichtung 2 innerhalb der Auswerteschaltung 8 einen analogen Signalverarbeitungsteil 10 und eine Recheneinheit 12 auf. Eine Schnittstelle 9 dient der Anzeige und/oder der Weiterleitung der Auswerteergebnisse.

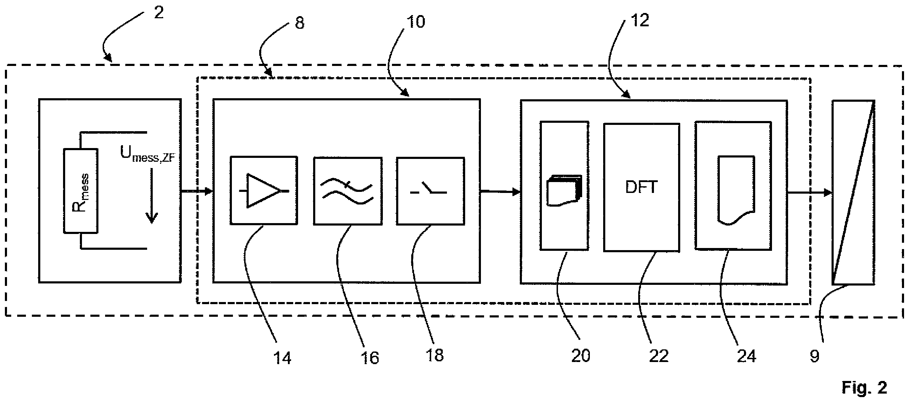

In **Fig. 2** ist ein funktionales Blockdiagramm der erfindungsgemäßen Überwachungsvorrichtung 2 dargestellt. Die an dem Messwiderstand Rₘₑₛₛ abgegriffene Spannung U_{mess,ZF} durchläuft zunächst innerhalb des analogen Signalverarbeitungsteils 10 der Auswerteschaltung 8 eine Verstärkerstufe 14, gefolgt von einem Tiefpassfilter 16, bevor sie einer Digitalisierungs-Hardware 18 mit einer Abtastschaltung zugeführt und dann als zeitdiskrete Abtastwertfolge der Spannungs-Messwerte weitergeleitet wird.

In der nachfolgenden Recheneinheit 12, die bevorzugt als Mikrocontroller ausgeführt ist, findet die digitale Signalverarbeitung statt. Nach Ermittlung der auf die aktuelle Netzfrequenz f_{Netz} synchronisierten Messfrequenz fₘₑₛₛ wird der Signalgenerator G veranlasst, eine entsprechend (nach-)synchronisierte Messspannung U_{mess,G} auszugeben. Sodann wird eine netzsynchrone Periode der Messspannung U_{mess,G} als Abtastwertfolge der Spannungs-Messwerte eingelesen, in einer Speichereinheit 20 zwischengespeichert und in einem DFT-Block 22 der Transformation unterzogen. Die komplexwertigen Ergebnisse der DFT werden dann in Verbindung mit weiteren digitalen Signalverarbeitungsalgorithmen 24 zur Bestimmung des komplexen Isolationswiderstands Z_{F} herangezogen. Der komplexwertige Isolationswiderstand Z_{F} als Auswerteergebnis wird über eine geeignete Schnittstelle 9 dem Benutzer signalisiert oder zur weiteren Verarbeitung übertragen.

## Patentansprüche

1. Verfahren zur Überwachung eines Isolationswiderstandes (R_{F}) in einem ungeerdeten Stromversorgungssystem (4) mit einer Netzspannung und einer Netzfrequenz (f_{Netz}), umfassend die Verfahrensschritte:
- Erzeugen einer harmonischen Wechselspannung als Messspannung (U_{mess,G}) mit einer einstellbaren Messfrequenz (fmess),
- Einkoppeln der Messspannung (U_{mess,G}) zwischen mindestens einem Leiter (L) des Stromversorgungssystems (4) und Erdpotential (E),
- Erfassen eines einem komplexwertigen Isolationswiderstand (Z_{F}) proportionalen Messstroms zwischen dem Leiter (L) des Stromversorgungssystems (4) und Erdpotential (E) durch Abtastung der an einem reellen Messwiderstand (Rₘₑₛₛ) abfallenden Spannung (U_{mess,ZF}), wobei die Abtastwerte eine Folge von Spannungs-Messwerten mit einer Abtastperiode bilden,
- Verwenden der Spannungs-Messwerte zur Bestimmung des komplexwertigen Isolationswiderstands (Z_{F}),
**dadurch gekennzeichnet, dass**
- eine Synchronisation der Messfrequenz (fₘₑₛₛ) auf die Netzfrequenz (f_{Netz}) durchgeführt wird,
- eine netzsynchrone Signalperiode der Spannungs-Messwerte gespeichert und einer diskreten Fourier-Transformation unterworfen wird, wobei die spektralen Komponenten der Netzspannung bei einer Rechteck-Fensterung im Zeitbereich in den Nullstellen einer si-Funktion im Spektralbereich zu liegen kommen.

2. Verfahren nach Anspruch 1,
**dadurch gekennzeichnet,**
**dass** die Synchronisation der Messfrequenz (fₘₑₛₛ) auf die Netzfrequenz (f_{Netz}) folgende Schritte umfasst:
- Messung der Netzfrequenz (f_{Netz}),
- Nachsteuern der Messfrequenz (fₘₑₛₛ) bei einer Änderung der Netzfrequenz (f_{Netz}), so dass die Messfrequenz (fₘₑₛₛ) und die Netzfrequenz (f_{Netz}) in einem geradezahligen Teilerverhältnis zueinander stehen.

3. Verfahren nach Anspruch 2,
**dadurch gekennzeichnet,**
**dass** das geradezahlige Teilerverhältnis 2^{m} = f_{Netz}/fₘₑₛₛ beträgt.

4. Verfahren nach Anspruch 2 oder 3,
**dadurch gekennzeichnet,**
**dass** die Messung der Netzfrequenz (f_{Netz}) periodisch nach einer einstellbaren Anzahl von n Abtastperioden erfolgt.

5. Verfahren nach einem der Ansprüche 2 bis 4,
**dadurch gekennzeichnet,**
**dass** bei einer Änderung der Netzfrequenz (f_{Netz}) die n zeitältesten Spannungs-Messwerte der gespeicherten Signalperiode durch die aktuellen n Abtastwerte ersetzt werden.

6. Verfahren nach Anspruch 5,
**dadurch gekennzeichnet,**
**dass** die einstellbare Anzahl n der zu aktualisierenden Spannungs-Messwerte einen Spannungs-Messwert bis alle eine gesamte Signalperiode repräsentierenden Spannungs-Messwerte umfassen kann.

7. Verfahren nach einem der Ansprüche 1 bis 6,
**dadurch gekennzeichnet,**
**dass** die komplexwertige diskrete Fourier-Transformierte der Spannungs-Messwerte als Grundlage zur Bestimmung eines ohmschen (R_{F}) und eines kapazitiven (Cₑ) Anteils des komplexwertigen Isolationswiderstands (Z_{F}) verwendet wird.

8. Verfahren nach einem der Ansprüche 1 bis 7,
**dadurch gekennzeichnet,**
**dass** eine Störsignalerkennung mit nachfolgender Unterdrückung des ermittelten Isolationswiderstands (R_{F}) durchgeführt wird.

9. Vorrichtung zur Überwachung eines Isolationswiderstandes (R_{F}) in einem ungeerdeten Stromversorgungssystem (4) mit einer Netzspannung und einer Netzfrequenz (f_{Netz}), mit einer Signalgeneratorschaltung (G) zur Erzeugung einer harmonischen Wechselspannung als Messspannung (U_{mess,G}) mit einer einstellbaren Messfrequenz (fₘₑₛₛ), mit einer Ankopplungsschaltung (6) zur Erfassung eines einem komplexwertigen Isolationswiderstand (Z_{F}) proportionalen Messstroms zwischen dem Leiter (L) des Stromversorgungssystems (4) und Erdpotential (E), mit einer Abtastschaltung zur Abtastung der an einem reellen Messwiderstand (Rₘₑₛₛ) abfallenden Spannung, wobei die Abtastwerte eine Folge von Spannungs-Messwerten mit einer Abtastperiode bilden,
**gekennzeichnet durch**
eine Recheneinheit (12) zur Ausführung einer Synchronisation der Messfrequenz (fₘₑₛₛ) auf die Netzfrequenz (f_{Netz}), zur Ausführung einer diskreten Fourier-Transformation einer netzsynchronen Signalperiode der Spannungsmesswerte, wobei die spektralen Komponenten der Netzspannung bei einer Rechteck-Fensterung im Zeitbereich in den Nullstellen einer si-Funktion im Spektralbereich zu liegen kommen, und zur Ausführung von Berechnungen zur Bestimmung des komplexwertigen Isolationswiderstands (Z_{F}) auf der Grundlage der diskreten Fourier-Transformierten sowie eine Speichereinheit (20) zur Speicherung einer Signalperiode der Spannungs-Messwerte.

## Claims

1. A method for monitoring an insulation resistance (R_{F}) in an ungrounded power supply system (4) having a mains voltage and a mains frequency (f_{Netz}), comprising the following method steps:
- generating a harmonic alternating voltage as a measuring voltage (U_{mess,G}) having a settable measuring frequency (fₘₑₛₛ),
- feeding the measuring voltage (U_{mess,G}) between at least one conductor (L) of the power supply system (4) and ground potential (E),
- capturing a measuring current, which is proportional to a complex-valued insulation resistance (Z_{F}), between the conductor (L) of the power supply system (4) and the ground potential (E) by sampling the voltage (U_{mess,ZF}) dropping at a real measuring resistance (Rₘₑₛₛ), the sampling values forming a sequence of voltage measuring values having a sampling period,
- using the voltage measuring values for determining the complex-valued insulation resistance (Z_{F}),
**characterized in that**
- the measuring frequency (fₘₑₛₛ) is synchronized to the mains frequency (f_{Netz}),
- a mains-synchronized signal period of the voltage measuring value is saved and subjected to a discrete Fourier transformation, the spectral components of the mains voltage being mapped to the zeros of a si-function in the spectral range when rectangular windowing takes place in the time domain.

2. The method according to claim 1,
**characterized in that**
the synchronization of the measuring frequency (fₘₑₛₛ) to the mains frequency (f_{Netz}) comprises the following steps:
- measuring the mains frequency (f_{Netz}),
- readjusting the measuring frequency (fₘₑₛₛ) when the mains frequency (f_{Netz}) is changed so that the measuring frequency (fₘₑₛₛ) and the mains frequency (f_{Netz}) have an even-numbered divider ratio with respect to each other.

3. The method according to claim 2,
**characterized in that**
the even-numbered divider ratio is 2^{m} = f_{Netz}/fₘₑₛₛ.

4. The method according to claim 2 or 3,
**characterized in that**
the mains frequency (f_{Netz}) is measured periodically according to a settable number of n sampling periods.

5. The method according to any one of the claim 2 to 4,
**characterized in that**
when the mains frequency (f_{Netz}) is changed, the n oldest voltage measuring values of the saved signal periods are replaced by the current n sampling values.

6. The method according to claim 5,
**characterized in that**
the settable number n of the voltage measuring values to be updated comprises one voltage measuring value to all voltage measuring values representing a complete signal period.

7. The method according to any one of the claims 1 to 6,
**characterized in that**
the complex-valued discrete Fourier transforms of the voltage measuring value is used as a basis for determining an ohmic (R_{F}) and a capacitive (Cₑ) portion of the complex-valued insulation resistance (Z_{F}).

8. The method according to any one of the claims 1 to 7,
**characterized in that**
an interference signal is identified having a subsequent suppression of the detected insulation resistance (R_{F}).

9. A device for monitoring an insulation resistance (R_{F}) in an ungrounded power supply system (4) having a mains voltage and a mains frequency (f_{Netz}), having a signal generator circuit (G) for generating a harmonic alternating voltage as a measuring voltage (U_{mess,G}) using a settable measuring frequency (f_{Mess}), having a coupling circuit (6) for capturing a measuring current, which is proportional to a complex-valued insulation resistance (Z_{F}), between the conductor (L) of the power supply system (4) and ground potential (E), having a sampling circuit for sampling the voltage drop at a real measuring resistance (Rₘₑₛₛ), the sampling values forming a sequence of voltage measuring values having a sampling period,
**characterized by**
a computing unit (12) for executing a synchronization of the measuring frequency (fₘₑₛₛ) to the mains frequency (f_{Netz}), for executing a discrete Fourier transformation of a mains-synchronous signal period of the voltage measuring values, the spectral components of the mains voltage being mapped to the zeros of a si-function in the spectral range when rectangular windowing takes place in the time domain, and for executing computations for determining the complex-valued insulation resistance (Z_{F}) based on the discrete Fourier transforms, and having a storage unit (20) for saving a signal period of the voltage measuring values.

## Revendications

1. Procédé pour la surveillance d'une résistance d'isolement (R_{F}) dans un système d'alimentation en énergie (4) qui n'est pas mis à la terre, ayant une tension du secteur et une fréquence du réseau (f_{Netz}), comprenant les étapes de procédure suivantes :
- générer une tension alternative harmonique comme tension de mesure (U_{mess,G}) ayant une fréquence de mesure (fₘₑₛₛ) qui peut être réglée,
- lier la tension de mesure (U_{mess,G}) entre au moins un conducteur (L) du système d'alimentation en énergie (4) et potentiel terrestre (E),
- détecter un courant de mesure, qui est proportionnel à la résistance d'isolement (Z_{F}) complexe en valeur entre le conducteur (L) du système d'alimentation en énergie (4) et le potentiel terrestre (E) par échantillonnage d'une chute de tension (U_{mess,ZF}) à une résistance de mesure réelle, les valeurs d'échantillonnage formant une séquence de valeurs de tension de mesure ayant une période d'échantillonnage,
- utiliser les valeurs de tension de mesure pour la détermination de la résistance d'isolement (Z_{F}) complexe en valeurs,
**caractérisé en ce que**
- synchroniser la fréquence de mesure (fₘₑₛₛ) sur la fréquence de réseau (f_{Netz})
- une période de signal synchronisée par réseau des valeurs de tension de mesure est stockée et soumise à une transformation de Fourier discrète, les composants spectraux de la tension du réseau se retrouvant dans la région spectrale via une fenêtre rectangulaire dans le domaine temporel dans les zéros dans une si-fonction.

2. Procédé selon la revendication 1,
**caractérisé en ce que**
la synchronisation de la fréquence de mesure (fₘₑₛₛ) à la fréquence de réseau (f_{Netz}) comprend les étapes suivantes :
- mesurer la fréquence de réseau (f_{Netz})
- réajuster la fréquence de mesure (fₘₑₛₛ) lors d'un changement de la fréquence de réseau (f_{Netz}) de sorte que la fréquence de mesure (fₘₑₛₛ) et la fréquence de réseau (f_{Netz}) sont proportionnées à une relation en partie paire.

3. Procédé selon la revendication 2,
**caractérisé en ce que**
la relation en partie paire est 2^{m} = f_{Netz}/fₘₑₛₛ.

4. Procédé selon la revendication 2 ou 3,
**caractérisé en ce que**
la fréquence de réseau (f_{Netz}) est mesurée périodiquement selon un nombre de n périodes d'échantillonnage qui peut être réglé.

5. Procédé selon l'une quelconque des revendications 2 à 4,
**caractérisé en ce que**
les n valeurs de tension de mesure les plus vieilles de la période de signal stockée sont remplacées par les n valeurs d'échantillonnage actuelles lors d'un changement de la fréquence de réseau (f_{Netz}).

6. Procédé selon la revendication 5,
**caractérisé en ce que**
le nombre n, qui peut être réglé, des valeurs de tension de mesure qui peuvent être actualisées comprend une valeur de tension de mesure à toutes les valeurs de tension de mesure représentant une période de signal entière.

7. Procédé selon l'une quelconque des revendications 1 à 6,
**caractérisé en ce que**
la transformée de Fourier complexe et discrète des valeurs de tension de mesure est utilisée comme base d'une détermination d'une part ohmique (R_{F}) et d'une part capacitive (Cₑ) de la résistance d'isolement (Z_{F}) complexe.

8. Procédé selon l'une quelconque des revendications 1 à 7,
**caractérisé en ce qu'**
une identification de signal non désiré ayant une suppression suivante de la résistance d'isolement (R_{F}) est effectuée.

9. Dispositif pour la surveillance d'une résistance d'isolement (R_{F}) dans un système d'alimentation en énergie (4) qui n'est pas mis à la terre ayant une tension du secteur et une fréquence du réseau (f_{Netz}), ayant un circuit de générateur de signaux (G) pour la génération d'une tension alternative harmonique comme tension de mesure (U_{mess,G}) par utilisant une fréquence de mesure (fₘₑₛₛ) qui peut être réglée, ayant un circuit de couplage (6) pour le captage d'un courant de mesure complexe en valeurs et proportionnel à une résistance d'isolement (Z_{F}) entre le conducteur (L) du système d'alimentation en énergie (4) et un potentiel terrestre (E), ayant un couplage d'échantillonnage pour l'échantillonnage de la tension retombé à une résistance de mesure (Rₘₑₛₛ) réelle, les valeurs d'échantillonnage représentant une suite des valeurs de tension de mesure par utilisant une période d'échantillonnage,
**caractérisé en ce qu'**
une unité de compte (12) pour l'effectuation d'une synchronisation de la fréquence mesurée (fₘₑₛₛ) à la fréquence de réseau (f_{Netz}), pour l'effectuation d'une transformation de Fourier discrète d'une période de signal synchrone au réseau des valeurs de tension de mesure, les composants spectraux de la tension du réseau se retrouvant dans la région spectrale via une fenêtre rectangulaire dans le domaine temporel dans les zéros dans une si-fonction, et pour l'effectuation des calculs pour la détermination de la résistance d'isolement (Z_{F}) complexe en valeurs à la base d'une transformée de Fourier discrète de même qu'une unité de stockage (20) pour stocker une période de signal des valeurs de tension de mesure.
